Europäisches Patentamt

(19) European Patent Office

Office européen des brevets

(11) Numéro de publication: **0 114 133**
**B1**

(12) # FASCICULE DE BREVET EUROPÉEN

(45) Date de publication du fascicule du brevet:
24.09.86

(51) Int. Cl.⁴: **H 01 L 21/00, H 01 F 41/14**

(21) Numéro de dépôt: **84400047.1**

(22) Date de dépôt: **10.01.84**

(54) Procédé de fabrication de conducteurs pour circuits intégrés, en technologie planar.

(30) Priorité: **13.01.83 FR 8300436**

(43) Date de publication de la demande:
**25.07.84 Bulletin 84/30**

(45) Mention de la délivrance du brevet:
**24.09.86 Bulletin 86/39**

(84) Etats contractants désignés:
**CH DE GB IT LI NL SE**

(56) Documents cité:
**EP-A-0 022 580**
**EP-A-0 057 738**
**FR-A-2 452 762**
**US-A-4 224 361**

**JOURNAL OF THE ELECTROCHEMICAL SOCIETY,
vol. 125, no. 6, juin 1978, pages 860-865 J.J. KELLY et
al.: "Electrochemical aspects of the beveling of
sputtered permalloy films"**

(73) Titulaire: **COMMISSARIAT A L'ENERGIE
ATOMIQUE Etablissement de Caractère
Scientifique Technique et Industriel, 31/33, rue
de la Fédération, F-75015 Paris (FR)**

(72) Inventeur: **Dargent, Bruno, 2, rue du Palais, F-38000
Grenoble (FR)**

(74) Mandataire: **Mongrédien, André, c/o BREVATOME
25, rue de Ponthieu, F-75008 Paris (FR)**

EP 0 114 133 B1

## Description

L'invention concerne un procédé de fabrication de conducteurs pour circuits intégrés, en technologie planar. Elle s'applique à la microélectronique et plus précisément à la fabrication de circuits intégrés. Elle concerne en particulier des conducteurs qui peuvent être enterrés dans une couche d'oxyde de silicium, par exemple, portée par un substrat de grenats magnétiques, pour la fabrication de mémoires à bulles magnétiques.

Le procédé de l'invention consiste essentiellement à réaliser des dépôts conducteurs enterrés dans un isolant recouvrant un substrat, de manière que ces dépôts conducteurs ne présentent pas de relief audessus de la surface du substrat; ce procédé peut donc être utilisé dans la réalisation de circuits intégrés, en technologie planar.

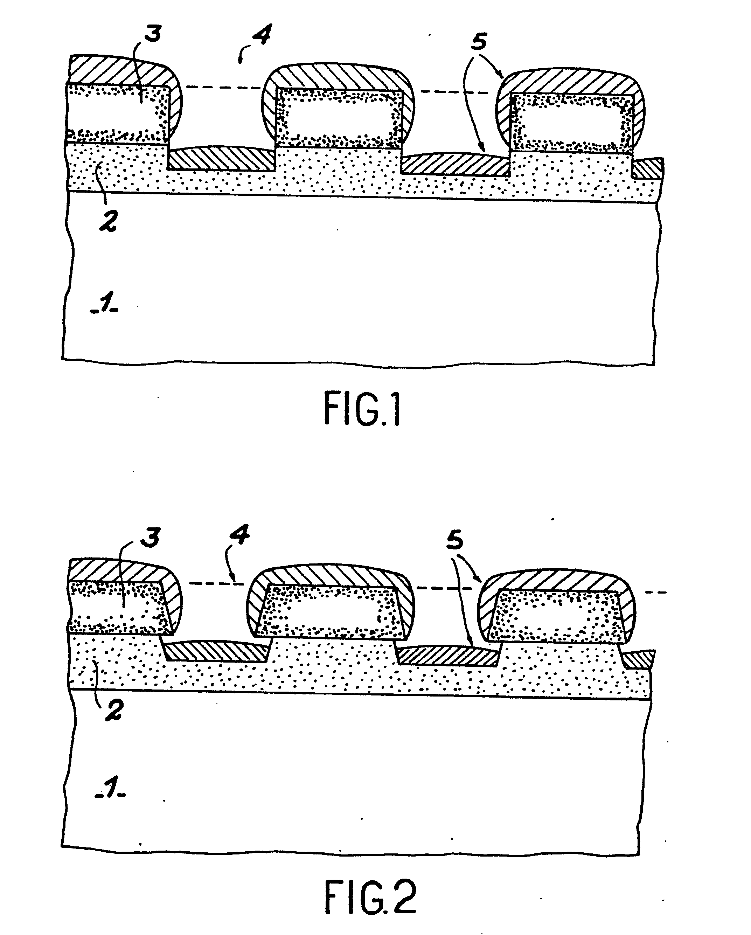

On connaît un procédé de fabrication de conducteurs pour circuits intégrés, en technologie planar. Ce procédé est par exemple celui qui est décrit dans la revue IEEE TRANSACTIONS AND ELECTRONIC DEVICES - Volume ED 2 - n°6 - juin 1980 - Article de B.M. WELCH intitulé "LSI Processing technology for Planar GaAs integrated circuits". Ce procédé est illustré par la figure 1. Il consiste essentiellement à déposer sur un substrat 1, une couche d'un matériau isolant 2 (tel que du silicium par exemple), puis à déposer sur cette couche 2 de matériau isolant, une couche 3 de masquage (telle qu'une résine par exemple). Cette couche de masquage est ensuite découpée jusqu'à la couche de matériau isolant, par insolation à travers un masque par exemple. Ce découpage permet d'obtenir des fenêtres 4 dans la couche de masquage, ces fenêtres correspondant aux conducteurs à obtenir. On grave ensuite des motifs dans la couche de matériau isolant 2, en regard des fenêtres 4, par exemple par ionisation réactive. Cette ionisation réactive est bien connue et elle consiste essentiellement à attaquer par ionisation la couche de matériau isolant, en atmosphère gazeuse par exemple. La couche de matériau isolant 2 étant gravée, on dépose alors un matériau conducteur 5 sur la couche de masquage et dans les motifs gravés dans la couche de matériau isolant 2. On élimine ensuite la couche de masquage 3 et le matériau conducteur qui la recouvre, par exemple par dissolution de la couche de masquage dans un solvant (acétone par exemple), en présence d'ultrasons. L'enlèvement de la couche de masquage (lift-off en anglais), est difficile si la couche conductrice qui la recouvre recouvre aussi les bords des fenêtres découpées dans la couche de masquage et atteint la couche de matériau isolant 2. Pour que l'enlèvement de la couche de masquage, par dissolution dans un solvant, s'opère convenablement, il faut que les flancs de la couche de masquage au voisinage des fenêtres soient bien verticaux, ce qui est très difficile à garantir avec les moyens de lithographie classiques. Dans le cas contraire, et surtout lorsque la gravure ionique réactive entraîne un durcissement de la surface de la couche de masquage, la dissolution de cette couche s'opère très difficilement sans utiliser des moyens mécaniques violents tels que des jets haute pression ou un brossage par exemple. Le dépôt de la couche conductrice doit être très directif pour ne pas couvrir les flancs de la couche de masquage au voisinage des fenêtres.

On connaît un autre procédé de fabrication de conducteurs pour circuits intégrés, en technologie planar. Ce procédé est décrit dans la revue IEEE TRANSACTIONS ON MAGNETICS - vol. MAG 16 - n°3 - mai 1980 dans l'article de Bernard J. ROMAN, intitulé "Effect of conductor crossing on propagation". Ce procédé, qui est illustré par la figure 2, consiste essentiellement à déposer sur une couche d'un substrat 1 une couche 2 d'un matériau isolant. On dépose ensuite sur cette couche de matériau isolant une couche 3 de masquage (en résine par exemple) qui est découpée par insolation à travers un masque. On grave ensuite des motifs dans la couche 2 de matériau isolant, par exemple par ionisation réactive, en regard des fenêtres 4 découpées dans la couche de masquage 3. Cette gravure du matériau isolant doit être latérale, de manière à provoquer, selon ce procédé, un élargissement des dimensions des motifs gravés dans la couche isolante, par rapport aux dimensions des fenêtres découpées dans la couche de masquage. On dépose ensuite sur la couche de masquage et au fond des motifs gravés dans la couche de matériau isolant 2, un matériau conducteur 5. On élimine ensuite la couche de masquage et le matériau conducteur qui la recouvre par attaque chimique de la couche de masquage.

L'élargissement des motifs gravés dans la couche de matériau isolant par gravure latérale entraîne une mauvaise définition des dimensions des conducteurs à obtenir. De plus, une surépaisseur du matériau conducteur déposé dans les motifs gravés, risque d'entraîner une jonction entre la couche de matériau déposée au fond des motifs et la couche du matériau déposée sur la couche de masquage; cette jonction rend difficile l'élimination de la couche de masquage par un solvant, en fin de procédé.

Le procédé de l'invention a pour but de remédier à ces inconvénients et notamment de faciliter l'élimination ou l'enlèvement des moyens de masquage et du matériau conducteur qui la recouvre, à la fin des opérations de fabrication.

Ce procédé permet notamment d'éviter une jonction entre la couche du matériau déposé dans les motifs gravés dans la couche isolante et le matériau conducteur déposé sur la couche de masquage. Ces buts sont atteints grâce à l'utilisation d'une couche de masquage supplémentaire, qui peut être gravée chimiquement.

L'invention concerne un procédé de fabrication de conducteurs pour circuits intégrés, en technologie planar dans lequel:
- on dépose sur un substrat une couche d'un matériau isolant,
- on dépose une nappe de masquage sur la couche de matériau isolant,
- on découpe dans cette nappe de masquage, jusqu'à la couche de matériau isolant, des fenêtres correspondant aux conducteurs à obtenir,
- on grave la couche de matériau isolant en regard des fenêtres,
- on dépose un matériau conducteur sur la nappe de masquage et dans les parties gravées de la couche de matériau isolant, en regard des fenêtres,
- on élimine la nappe de masquage et le matériau conducteur qui la recouvre, caractérisé en ce qu'il consiste à choisir une nappe de masquage comportant une première couche recouvrant la couche de matériau isolant, et une deuxième couche de masquage recouvrant la première couche, la première couche étant découpée chimiquement en regard des fenêtres, après découpage de la deuxième couche de masquage, les bords de la première couche, sur le pourtour des fenêtres, étant érodés par le découpage chimique.

Selon une autre caracréristique, la première couche est une couche métallique qui est découpée chimiquement par un solvant.

Selon une autre caractéristique, la deuxième couche de masquage est une résine découpée selon lesdites fenêtres, par insolation à travers un masque.

Selon une autre caractéristique, la couche de matériau isolant est gravée selon une méthode de gravure ionique réactive.

Selon une autre caractéristique, la nappe de masquage et le matériau conducteur qui la recouvre sont éliminés par voies chimique.

Selon une autre caractéristique, le procédé consiste en outre à utiliser un alliage de fer et de nickel pour constituer la première couche de la nappe de masquage.

Les caractéristiques et avantages de l'invention ressortiront mieux de la description qui va suivre en regard des figures schématiques annexées dans lesquelles:
- la figure 1, qui a déjà été décrite, illustre schématiquement un procédé connu dans l'état de la technique;
- la figure 2, qui a déjà été décrite, illustre schématiquement un autre procédé connu de l'état de la technique;
- la figure 3 illustre schématiquement en a, b, c, d les principales étapes du procédé de l'invention.

Les figures 1 et 2 ont déjà été décrites pour mieux comprendre les procédés essentiels de l'état de la technique.

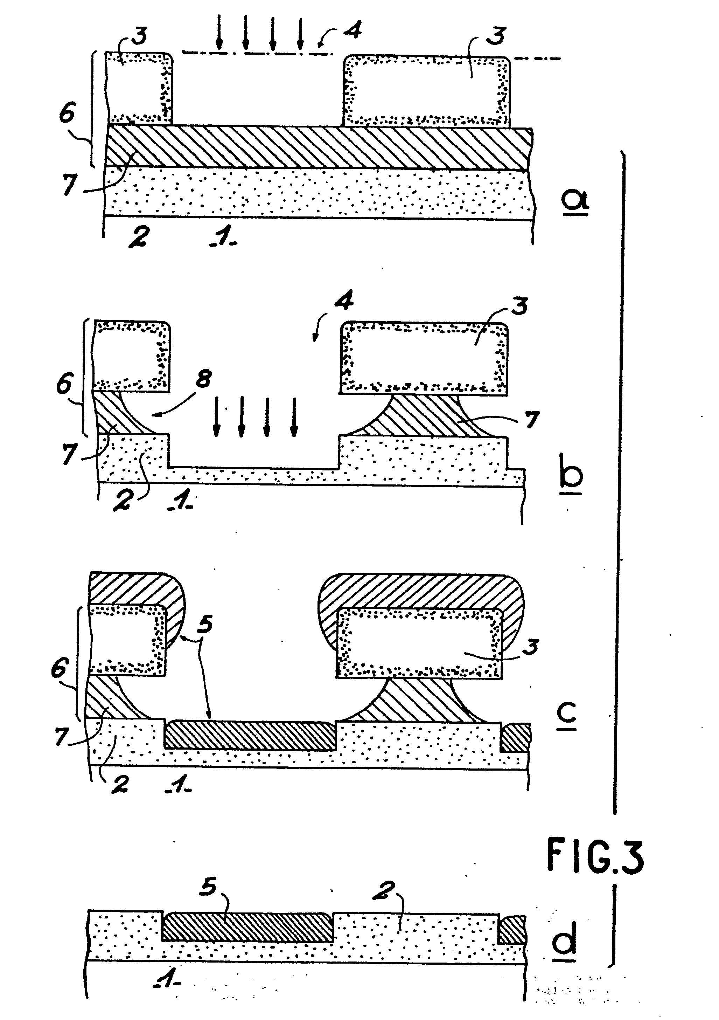

Comme le montre la figure 3 en (a), le procédé consiste tout d'abord à déposer sur un substrat 1 (tel qu'un grenat magnétique par exemple dans le cas de fabrication de conducteurs pour mémoire à bulle), une couche d'un matériau isolant 2, tel que de l'oxyde de silicium par exemple. On dépose ensuite sur cette couche 2 de matériau isolant, une nappe 6 de masquage: cette nappe comme on le verra plus loin en détail, comprend une première couche 7 d'un matériau, qui peut etre découpée chimiquement, et une deuxième couche 3 qui peut être découpée par insolation à travers un masque; le découpage de la deuxième couche 3 permet d'obtenir des fenêtres correspondant aux émplacements des conducteurs à enterrer dans des motifs gravés dans la couche de matériau isolant 2. La couche 3 de masquage peut être une résine par exemple.

Ensuite, comme le montre la figure en (b), après découpage de la couche de masquage 3, la couche 7 qui peut être une couche métallique (alliage de fer et de nickel par exemple), est découpée chimiquement par un solvant. Cette découpe chimique, effectuée en regard des fenêtres 4 de la couche de masquage 3, permet d'éroder les bords 8 de la première couche 7 de la nappe de masquage 6, sur le pourtour des fenêtres, de manière que sur tout ce pourtour, les bords de la première couche 7 de masquage, soient en retrait par rapport aux rebords de la deuxième couche 3 de masquage. La découpe chimique de la première couche métallique 7 nécessite bien entendu l'utilisation d'un solvant approprié déposé sur cette couche, en regard de chaque fenêtre 4.

Ensuite, on grave par ionisation réactive, par exemple en atmosphère gazeuse de trifluorométhane, des motifs correspondant à l'implantation des conducteurs à obtenir dans la couche de matériau isolant 2. Cette ionisation réactive est bien entendu contrôlée en fonction de l'épaisseur souhaitée des conducteurs.

Ensuite, comme le montre la figure en (c), on dépose un matériau conducteur 5 (de l'or par exemple) dans les motifs gravés, ainsi que sur la deuxième couche 3 de masquage.

Enfin, comme représenté sur la figure en (d), on enlève par voie chimique par exemple (lift-off), la première couche 7 métallique, la deuxième couche 3 de masquage ainsi que le matériau 5 qui recouvre cette couche de masquage. On obtient alors un substrat 1 recouvert de la couche de matériau isolant 2, dans laquelle sont enterrés les conducteurs 5. On a ainsi réalisé une implantation de conducteurs, en technologie planar, particulièrement utile dans les mémoires à bulles par exemple. La couche 3 de matériau de masquage peut être par exemple une résine soluble dans l'acétone. La couche 3 peut présenter, par exemple, une épaisseur de 1µ, tandis que la deuxième couche 7 de fer et de nickel peut présenter une épaisseur de 5.000 à. L'épaisseur des conducteurs 5 déposés dans les motifs gravés dans la couche 2 de matériau isolant peut être de 2.700 à, alors que l'épaisseur de cette couche isolante est voisine de 3.000 à. Ce procédé de fabrication qui est particulièrement utile dans la technologie des mémoires à bulles, peut bien entendu être utilisé dans la fabrication d'autres circuits.

## Revendications

1. Procédé de fabrication de conducteurs pour circuits intégrés, en technologie planar, dans lequel:
- on dépose sur un substrat (1), une couche (2) d'un matériau isolant,
- on dépose une nappe de masquage (6) sur la couche (2) de matériau isolant,
- on découpe dans cette nappe (6) de masquage, jusqu'à la couche (2) de matériau isolant, des fenêtres (4) correspondant aux conducteurs à obtenir,
- on grave la couche (2) de matériau isolant en regard des fenêtres (4),
- on dépose un matériau conducteur (5) sur la nappe de masquage (6) et dans les parties gravées de la couche de matériau isolant (2), en regard des fenêtres (4),
- on élimine la nappe de masquage (6), et le matériau conducteur qui la recouvre,
caractérisé en ce qu'il consiste à choisir une nappe (6) de masquage comportant une première couche (7) recouvrant la couche (2) de matériau isolant, et une deuxième couche (3) de masquage recouvrant la première couche (7), la première couche étant découpée chimiquement (7), en regard des fenêtres, après decoupage de la deuxième (3) couche de masquage, les bords de la première couche (7), sur le pourtour des fenêtres (4) étant érodés par le découpage chimique.

2. Procédé selon la revendication 1, caractérisé en ce que la première couche (7) est une couche métallique qui est découpée chimiquement par un solvant.

3. Procédé selon la revendication 1, caractérisé en ce que la deuxième couche de masquage (3) est une résine decoupée selon lesdites fenêtres (4), par insolation à travers un masque.

4. Procédé selon la revendication 3, caractérisé en ce que la couche (2) de matériau isolant est gravée selon une méthode de gravure ionique réactive.

5. Procédé selon la revendication 4, caractérisé en ce que la nappe de masquage (6) et le matériau conducteur qui la recouvre, sont éliminés par voie chimique.

6. Procédé selon la revendication 5, caractérisé en ce qu'il consiste,à utiliser un alliage de fer et de nickel pour constituer la première couche (7) de la nappe de masquage (6).

## Patentansprüche

1. Verfahren zur Herstellung von Leitern für integrierte Schaltungen in Planartechnologie, bei dem man:
- auf ein Substrat (1) eine Isolierstoffschicht (2) aufbringt,
- auf der Isolierstoffschicht (2) eine Maskenabdeckung (6) aufbringt,
- in der Maskenabdeckung (6) bis zu der Isolierstoffschicht (2) Fenster (4), die den zu erhaltenden Leitern entsprechen, ausschneidet,
- die Isolierstoffschicht (2) an den Fenstern (4) ätzt,
- auf die Maskenabdeckung (6) und in die geätzten Partien der Isolierstoffschicht (2) der Fenster (4) Leitermaterial (5) bringt,
- die Maskenabdeckung (6) und das sie bedeckende Leitermaterial entfernt,
dadurch gekennzeichnet, daß eine Maskenabdeckung (6) gewählt wird, welche eine die Isolierstoffschicht (2) bedeckende erste Schicht (7) und eine die erste Schicht (7) bedeckende zweite Maskierschicht (3) enthält, wobei nach dem Schneiden der zweiten Maskierschicht (3) die erste Schicht bei den Fenstern chemisch geschnitten wird, wobei die Ränder der ersten Schicht (7) am Umfang der Fenster (4) durch das chemische Schneiden erodiert werden.

2. Verfahren nach Anspruch 1, dadurch gekennzeichnet, daß die erste Schicht (7) eine metallische Schicht ist, die durch ein Lösungsmittel chemisch geschnitten wird.

3. Verfahren nach Anspruch 1, dadurch gekennzeichnet, daß die zweite Maskierschicht (3) aus Harz besteht, welches entsprechend den Fenstern (4) durch Bestrahlung durch die Maske hindurch geschnitten wird::

4. Verfahren nach Anspruch 3, dadurch gekennzeichnet, daß die Isolierstoffschicht (2) durch ein reaktives Ionenätzverfahren geätzt wird.

5. Verfahren nach Anspruch 4, dadurch gekennzeichnet, daß die Maskenabdeckung (6) und das sie bedeckende Leitermaterial chemisch entfernt werden.

6. Verfahren nach Anspruch 5, dadurch gekennzeichnet, daß zur Bildung der ersten Schicht (7) der Maskenabdeckung (6) eine Eisen-Nickel-Legierung verwendet wird.

## Claims

1. Process for the preparation of conductors for integrated circuits, of planar configuration, wherein:
a layer (2) of an insulating material is deposited on a substrate (1),
a masking sheet (6) is deposited on the layer (2) of insulating material,
windows (4) corresponding to the conductors to be obtained are cut in this masking sheet (6), as far as the layer (2) of insulating material,
the layer (2) of insulating material is engraved opposite the windows (4),
a conducting material (5) is deposited on the masking sheet (6) and in the engraved portions of the layer of insulating material (2), opposite the windows (4),

the masking sheet (6) and the conducting material which covers the latter are removed, characterized in that the said process consists in selecting a masking sheet (6) including a first layer (7) covering the layer (2) of insulating material and a second masking layer (3) covering the first layer (7), the first layer being cut away chemically (7), opposite the windows, after the cutting of the second masking layer (3), the borders of the first layer (7) on the periphery of the windows (4) being eroded by the chemical cutting away.

2. Process according to Claim 1, characterized in that the first layer (7) is a metallic layer phich is cut away chemically by a solvent.

5. Process according to Claim 1, characterized in that the second masking layer (3) is a resin cut away according to the said windows (4) by insolation through a mask.

4. Process according to Claim 3, characterized in that the layer (2) of insulating material is engraved in accordance with a method of reactive ionic engraving.

5. Process according to Claim 4, characterized in that the masking sheet (6) and the conducting material which covers the latter are removed by chemical means.

6. Process according to Claim 5, characterized in that it consists in using an alloy of iron and nickel to form the first layer (7) of the masking sheet (6).

FIG.1

FIG.2

FIG.3